# FASCICULE DE BREVET EUROPEEN

(11) **EP 1 098 559 B1**
(45) Date de publication et mention de la délivrance du brevet: **07.02.2007**
(21) Numéro de dépôt: 00402849.4
(22) Date de dépôt: 16.10.2000
(51) Int. Cl.: H05K 13/00, H05K 3/00, G03F 7/20

(54) **Dispositif de transfert et de supportage de panneaux**
Einrichtung zum Befördern und Halten von plattenförmigem Material
Transport and holding device for panels

(30) Priorité: 03.11.1999 FR 9913726
(43) Date de publication de la demande: 09.05.2001
(73) Titulaire: AUTOMA-TECH, 27100 Val de Reuil (FR)
(72) Inventeur: Boureau, Damien, 76000 Rouen (FR); Clement, Xavier, 27400 Louviers (FR)
(74) Mandataire: Dronne, Guy

(56) Documents cités:
- US-A- 4 555 630

## Description

La présente invention a pour objet un dispositif de transfert et de supportage de panneaux, notamment de panneaux de circuit imprimé, et son application à une installation d'exposition à une source de rayonnement desdits panneaux voir par exemple US-A-4 555 630.

La réalisation de circuits imprimés comporte notamment comme étape celle de graver par différentes techniques un dépôt de cuivre réalisé sur une ou deux faces du panneau isolant afin de définir les pistes conductrices du circuit imprimé.

D'une part, ces panneaux peuvent présenter des dimensions importantes, par exemple 610 mm x 762 mm, alors que leur épaisseur tend à se réduire puisqu'elle peut descendre de façon courante jusqu'à 50 µm et dans des cas exceptionnels jusqu'à 5µm. On comprend dès à présent que la manipulation de tels panneaux est délicate.

D'autre part, lorsque les panneaux de circuit imprimé sont double face, il est bien sûr nécessaire de procéder à cette gravure sur les deux faces de celui-ci. Lorsque l'étape de gravure consiste à exposer à une source lumineuse le panneau à travers un cliché donnant la forme des pistes conductrices, il est possible de procéder à cette opération simultanément sur les deux faces du panneau de circuit imprimé.

Il se développe actuellement de nouvelles techniques de gravure des pistes conductrices qui consistent à remplacer l'opération d'insolation à travers un cliché par une opération de traitement de la couche de matériau photosensible ou de la couche de réserve disposée sur la feuille de matériau conducteur par le déplacement d'un faisceau laser, l'impact du faisceau laser provoquant la transformation locale de la couche de réserve et permettant, après enlèvement par la partie de la couche de réserve non-transformée, la gravure de la couche de matériau conducteur. Cependant, dans ce cas, il est impossible de procéder simultanément à cette opération à l'aide du faisceau laser sur les deux faces du circuit imprimé. Il est donc nécessaire de présenter dans la machine dite d'exposition successivement chaque face du panneau.

Selon d'autres techniques alternatives, le faisceau laser réalise directement l'ablation de la couche de réserve, ou encore aucune couche de réserve n'est utilisée et le faisceau laser réalise directement l'ablation de la couche conductrice.

On comprend également que, compte tenu de ses dimensions et de sa faible épaisseur, le retournement du panneau, pour permettre la présentation successive de ses deux faces dans la machine, soulève de grandes difficultés. En outre, on comprend qu'une station de retournement de ce panneau augmenterait très sensiblement le volume et donc l'encombrement de l'ensemble de la machine d'exposition si l'on y inclut les moyens de transfert qu'on doit lui associer pour rendre l'opération entièrement automatique et accroîtrait le temps de ces opérations.

Un objet de la présente invention est de fournir un dispositif de transfert et de supportage de panneaux double face et notamment de panneaux de circuit imprimé qui permette la présentation et le positionnement successivement de chacune des faces du panneau dans la machine d'exposition et qui ne présente pas les inconvénients de machine fonctionnant sur le principe du retournement du panneau.

Pour atteindre ce but, selon l'invention, le dispositif de transfert et de supportage d'un panneau double face, notamment d'un panneau de circuit imprimé, se caractérise en ce qu'il comprend :
- un plateau inférieur présentant une surface supérieure plane et horizontale de référence pour recevoir la face inférieur dudit panneau,
- un plateau supérieur présentant une surface inférieure plane et horizontale de référence pour recevoir la face supérieure dudit panneau ; et
- des moyens de déplacement pour déplacer séparément lesdits plateaux respectivement dans deux plans horizontaux ;
chacun desdits plateaux étant muni de moyens non mécaniques, commandables pour plaquer une face dudit panneau sur la surface de référence dudit plateau, lorsque les moyens pour plaquer sont activés ;
- ledit dispositif comprenant en outre des moyens commandables de soulèvement dudit panneau, lesdits moyens de soulèvement ne faisant pas saillie hors de la surface de référence d'un plateau lorsqu'ils sont dans un état non activés et étant aptes à appliquer ledit panneau contre la surface de référence dudit plateau supérieur lorsqu'ils sont activés.

On comprend que, grâce à la présence des plateaux respectivement supérieur et inférieur, chaque face du panneau peut être introduite dans la machine d'exposition tout en maintenant un positionnement du panneau dans la direction verticale très précis. En effet, les surfaces de référence de chacun des panneaux peuvent être usinées avec une très grande précision et ce positionnement selon la direction verticale est maintenu du fait que les plateaux sont seulement déplacés selon la direction horizontale.

Selon un mode préféré de réalisation, les moyens pour plaquer sont des micro-buses d'aspiration débouchant dans la surface de référence dudit plateau et régulièrement réparties dans ladite surface.

De préférence également, les moyens de soulèvement sont des micro-vérins disposés régulièrement dans la surface de référence dudit plateau inférieur, chaque micro-vérin comportant une tige mobile selon la direction orthogonale à la surface de référence, lesdites tiges, en position non activée, étant entièrement en retrait par rapport à ladite surface de référence.

Grâce à l'utilisation de micro-buses d'aspiration et de micro-vérins de soulèvement, d'une part, la planéité du panneau peut être maintenue même si son épaisseur est très réduite et, d'autre part, le transfert du panneau d'un plateau à l'autre plateau peut être réalisé sans risquer d'introduire dans le panneau des déformations localisées qui seraient incompatibles avec le type de traitement qu'il doit subir.

Un autre objet de l'invention est de fournir une installation d'exposition à une source de rayonnement de panneaux de circuit imprimé double face qui utilise le dispositif de transfert et de supportage défini précédemment.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées, sur lesquelles :
- les figures 1A à 1C illustrent le principe de l'invention dans le cas où elle est appliquée à une machine d'exposition, notamment par faisceau laser ;
- la figure 2 et une vue de dessus de la surface de référence d'un plateau ;
- la figure 3 est une vue en coupe longitudinale d'un plateau selon la ligne III-III de la figure 2 ;
- la figure 4 est une vue en coupe verticale d'un micro-vérin ; et
- la figure 5 est une vue en coupe verticale d'une micro-buse.

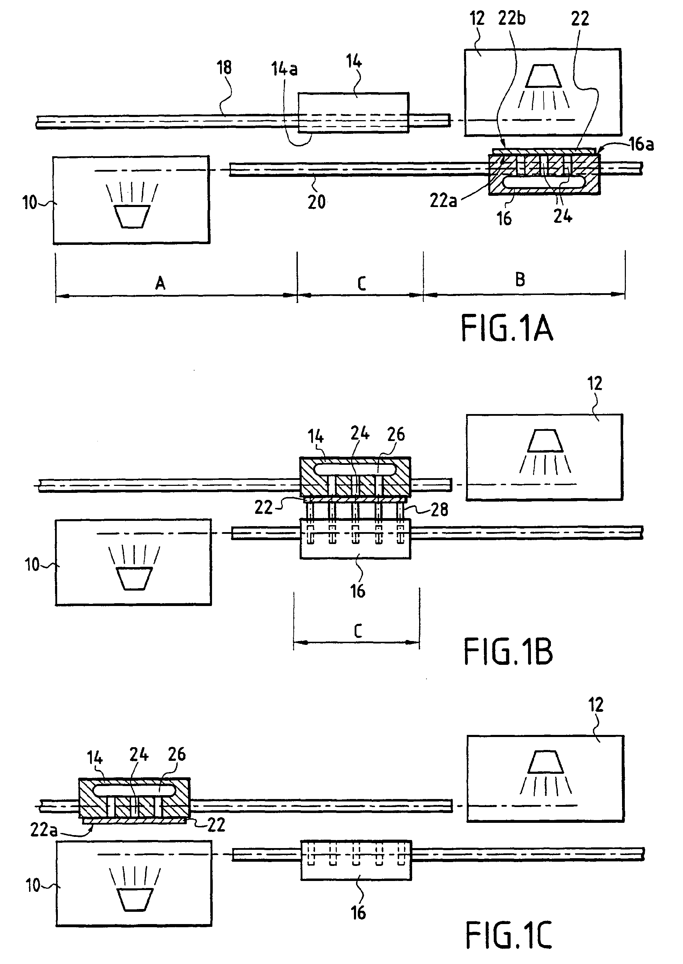

En se référant tout d'abord aux figures 1A à 1C, on va décrire l'ensemble du dispositif de transfert et de supportage utilisé dans le cadre d'une installation d'exposition de panneaux de circuit imprimé à un faisceau laser. L'installation comporte un bloc optique inférieur 10 destiné à traiter la face inférieure du panneau et un bloc optique supérieur 12 destiné à traiter la face supérieure de ce même panneau. Les blocs, respectivement inférieur 10 et supérieur 12, sont décalés dans un plan horizontal pour occuper des zones repérées par les lettres A et B, une zone de transfert C étant réservée entre les zones A et B.

Par installation d'exposition de circuits imprimés par faisceau laser, il faut entendre une technique qui est en elle-même maintenant bien connue et qui consiste à traiter la couche de réserve déposée sur la couche métallique du circuit imprimé par un faisceau laser et qui, par ses points d'impact, modifie l'état de la couche de réserve pour permettre ultérieurement son enlèvement aux endroits qui n'ont pas été frappés par le faisceau laser. On sait qu'ultérieurement, par des étapes d'attaque chimique, la couche conductrice ne subsistera que sur les zones insolées.

Par installation d'insolation, il faut également comprendre des machines dans lesquelles le faisceau laser réalise directement l'ablation des zones souhaitées de la couche de réserve où encore des machines dans lesquelles on n'utilise pas de couche de réserve et le faisceau laser réalise directement l'ablation des zones souhaitées de la couche conductrice.

Il pourrait également s'agir d'une machine d'exposition de type classique dans le cas où l'insolation de la face supérieure et de la face inférieure du panneau est réalisée par deux ensembles différents.

Le dispositif de transfert et de supportage proprement dit est essentiellement constitué par deux plateaux, respectivement un plateau supérieur 14 et un plateau inférieur 16 qui sont assujettis à se déplacer dans des plans horizontaux parallèles matérialisés par des rails supérieurs horizontaux 18 et des rails inférieurs horizontaux 20. Plus précisément, les rails supérieurs 18 permettent de déplacer le plateau 14 entre la zone de transfert C et la zone A correspondant au bloc optique inférieur 10 et les rails inférieurs 20 permettent le déplacement horizontal du plateau inférieur 16 entre la zone de transfert C et la zone B occupée par le bloc optique supérieur 12.

Les plateaux comportent des surfaces de référence, respectivement 14a et 16a, qui sont rigoureusement horizontales et d'une grande planéité. On comprend que cette planéité et cette horizontalité sont maintenues quelle que soit la position du plateau 14 ou du plateau 16. Ces surfaces de référence 14a et 16a sont destinées à recevoir une des faces du panneau à traiter. Ces surfaces de référence ont donc des dimensions supérieures à la plus grande dimension de panneau à traiter.

Le mode de fonctionnement de cette installation est le suivant. Dans un premier temps, le panneau, par exemple le panneau de circuit imprimé 22, est disposé par sa face inférieure 22a sur la surface de référence 16a du plateau inférieur 16. Ce plateau est amené devant le bloc optique supérieur 12. Le plateau sert également de support pour le panneau de circuit imprimé 22 durant la phase d'exposition de sa face supérieure 22b.

Dans l'étape suivante, le plateau inférieur 16 est amené dans la zone de transfert C en regard du plateau supérieur 14. Dans cette position, le panneau 22 est soulevé du plateau inférieur 16 pour être appliqué sur la surface de référence 14a du plateau supérieur 14 et pour être maintenu dans cette position. C'est ce qui est représenté sur la figure 1B. Enfin, le plateau supérieur 14 est déplacé pour être amené dans la zone A du bloc optique inférieur 10. Dans cette position, le plateau supérieur 14 sert d'élément de supportage du panneau 22 pour l'insolation par faisceau laser de sa face inférieure 22a. Après cette opération, on comprend que l'on a traité successivement les faces supérieure puis inférieure du panneau 22, l'intégralité de l'opération d'insolation étant ainsi réalisée.

Pour permettre le maintien du panneau sur les surfaces de référence 16a et 14a des plateaux 16 et 14, ceux-ci sont équipés, de préférence, de moyens d'aspiration représentés schématiquement par les buses 24 et 26 qui débouchent respectivement dans les surfaces de référence des plateaux supérieur et inférieur. Ces moyens d'aspiration seront décrits en détails ultérieurement. Pour maintenir le panneau sur la surface de référence du plateau, on pourrait utiliser d'autres moyens, par exemple mécaniques ou magnétiques. Cependant, la solution par aspiration paraît préférable.

Pour permettre le soulèvement du panneau 22 depuis le plateau inférieur 16 vers le plateau 14, le plateau inférieur 16 est équipé de moyens de soulèvement constitués, de préférence, par des micro-vérins 28 à déplacements verticaux. L'actionnement de ces micro-vérins permet de soulever l'intégralité du panneau par sa face inférieure pour amener sa face supérieure au contact de la surface de référence 14a du plateau supérieur 14. Dans l'état non activé, les tiges des micro-vérins sont en retrait par rapport à la surface de référence. Pour permettre le soulèvement du panneau à partir du plateau inférieur jusqu'au plateau supérieur, on pourrait utiliser des moyens magnétiques solidaires du plateau supérieur ou des jets d'air sous pression produits par le plateau inférieur. On pourrait également prévoir des moyens mécaniques extérieurs au plateau inférieur. Cependant, la solution par micro-vérins paraît préférable.

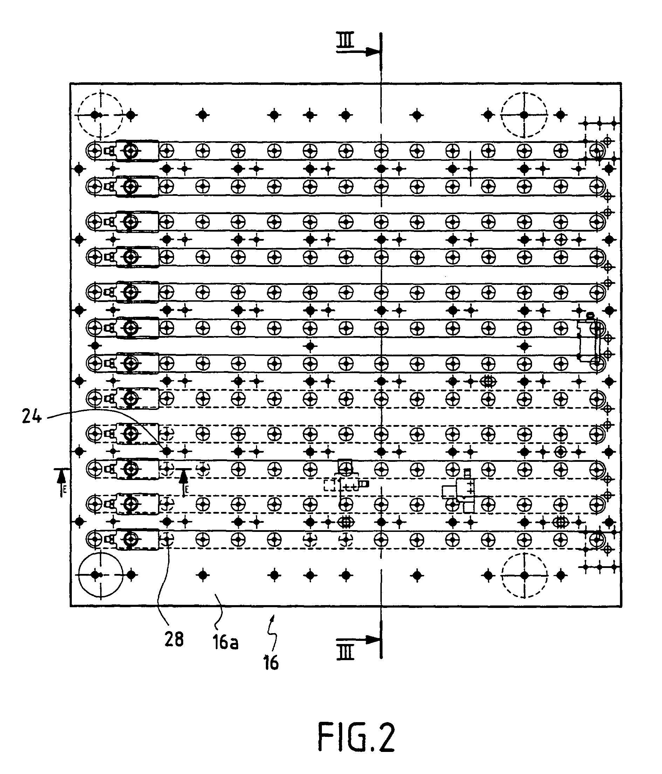

Sur la figure 2, on a représenté un mode préféré de réalisation du plateau inférieur 16, cette figure montrant plus particulièrement la surface de référence 16a de ce plateau. Sur cette figure, on a représenté l'extrémité des buses d'aspiration 24 qui sont disposées selon des lignes parallèles. De préférence, ces buses d'aspiration sont du type dans lequel l'aspiration est coupée si la sortie de la buse n'est pas obturée par une partie de l'objet à saisir. De même, sur cette figure, on a représenté les extrémités des micro-vérins 28 qui sont également disposés selon des lignes parallèles à celles des buses d'aspiration.

Il est important de relever que les buses d'aspiration sont régulièrement réparties dans la surface de référence, qu'elles ont un diamètre d'orifice réduit et qu'elles sont en grand nombre. On comprend qu'ainsi, d'une part, en commandant ces buses, on obtient une solidarisation uniformément répartie de l'ensemble du panneau sur la surface de référence. D'autre part, le diamètre réduit de ces buses n'altère pas significativement la planéité de la surface de référence. De la même manière, les sections des extrémités des micro-vérins sont de diamètre réduit et ces micro-vérins sont en nombre élevé et régulièrement répartis. On comprend qu'ainsi, lors du soulèvement du panneau, même si celui-ci présente une épaisseur réduite, il est maintenu rigoureusement plan jusqu'à son application sur la face inférieure de référence du plateau supérieur 14. Dans cette position, la commande des buses d'aspiration du plateau supérieur 14 assure la solidarisation de ce panneau sur la face de référence inférieure du plateau supérieur en maintenant encore la planéité du panneau.

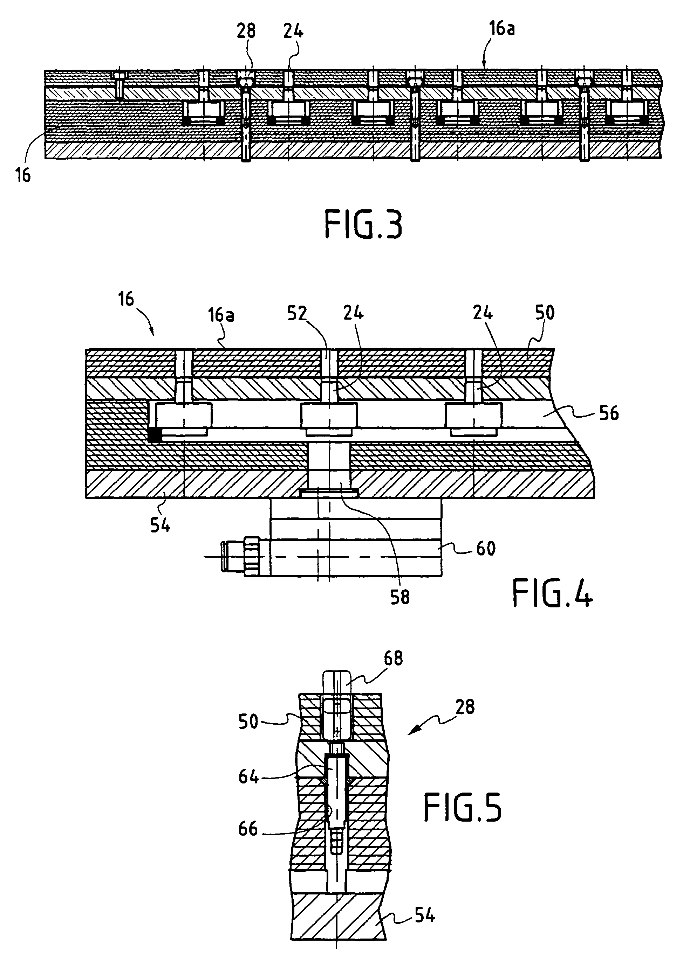

La figure 3 montre un mode réalisation préféré du plateau inférieur 16. Sur cette vue, on a représenté les micro-vérins 28 et les buses d'aspiration 24.

Comme le montre mieux la figure 4, le plateau 16 comprend une plaque supérieure 50 constituant la surface de référence 16a et percée de trous 52 correspondant aux buses d'aspiration 24. Il comprend également une plaque inférieure 54 qui définit des évidements 56 de positionnement et le réseau d'aspiration.

Cet évidemment communique avec un orifice 58 ménagé dans la plaque inférieure 54 et qui est relié à une pompe à vide 60.

La figure 5 montre un micro-vérin 28 dont la tige 64 est montée coulissante dans un évidement 66 de la plaque supérieure du plateau. La tige 64 se termine par une tête 68 réalisée de préférence en PVC pour éviter d'endommager le panneau de circuit imprimé. Sur cette figure, la tête 68 est représentée en position sortie.

## Revendications

1. Dispositif de transfert et de supportage d'un panneau double face (22), notamment d'un panneau de circuit imprimé, **caractérisé en ce qu'**il comprend :
- un plateau inférieur (16) présentant une surface supérieure plane et horizontale de référence pour recevoir la face inférieure dudit panneau,
- un plateau supérieur (14) présentant une surface inférieure plane et horizontale de référence pour recevoir la face supérieure dudit panneau ; et
- des moyens de déplacement (18, 20) pour déplacer séparément lesdits plateaux respectivement dans deux plans horizontaux ;
chacun desdits plateaux étant muni de moyens non mécaniques, commandables (24) pour plaquer une face dudit panneau sur la surface de référence dudit plateau, lorsque les moyens pour plaquer sont activés ;
- ledit dispositif comprenant en outre des moyens commandables de soulèvement (28) dudit panneau, lesdits moyens de soulèvement ne faisant pas saillie hors de la surface de référence d'un plateau lorsqu'ils sont dans un état non activé et étant aptes à appliquer ledit panneau contre la surface de référence dudit plateau supérieur lorsqu'ils sont activés.

2. Dispositif selon la revendication 1, **caractérisé en ce que** lesdits moyens pour plaquer sont des micro-buses d'aspiration débouchant dans la surface de référence dudit plateau et régulièrement réparties dans ladite surface.

3. Dispositif selon l'une quelconque des revendications 1 et 2, **caractérisé en ce que** lesdits moyens de soulèvement sont des micro-vérins disposés régulièrement dans la surface de référence dudit plateau inférieur, chaque micro-vérin comportant une tige mobile selon la direction orthogonale à la surface de référence, lesdites tiges, en position non activée, étant entièrement en retrait par rapport à ladite surface de référence.

4. Installation d'exposition à une source de rayonnement de panneaux de circuit imprimé double face, **caractérisée en ce qu'**elle comprend :
- un ensemble supérieur (12) d'émission dudit rayonnement ;
- un ensemble inférieur (10) d'émission dudit rayonnement décalé par rapport audit ensemble supérieur d'émission dans un direction horizontale ; et
- un dispositif de transfert du panneau disposée entre lesdits ensembles d'émission supérieur et inférieur selon l'une quelconque des revendications 1 à 3,
- lesdits moyens de déplacement étant commandés pour déplacer séparément ledit plateau inférieur entre la station de transfert et l'ensemble d'émission supérieur et ledit plateau supérieur entre ladite station de transfert et ledit ensemble d'émission inférieur.

## Claims

1. A device for transferring and supporting a double-sided panel (22), in particular a printed circuit panel, the device being **characterised in that** it comprises:
- a bottom slab (16) having a top reference surface that is plane and horizontal for receiving the bottom face of said panel;
- a top slab (14) having a bottom reference surface that is plane and horizontal for receiving the top face of said panel; and
- displacement means (18, 20) for moving said slabs separately in two respective horizontal planes;
each of said slabs being provided with non-mechanical holder means that are controllable (24) for pressing one face of said panel against the reference surface of said slab, when the holder means are activated;
- said device further comprising controllable lifting means (28) for controlling said panel, said lifting means not projecting from the reference surface of a slab when they are in a non-activated state, and being suitable for pressing said panel against the reference surface of said top slab when they are activated.

2. A device according to claim 1, **characterised in that** said holder means are suction micro-nozzles opening out in the reference surface of said slab and regularly distributed over said surface.

3. A device according to claim 1 or 2, **characterised in that** said lifting means are micro-actuators disposed regularly in the reference surface of said bottom slab, each micro-actuator having a moving rod that moves in a direction orthogonal to the reference surface, said rods when in the non-activated position being completely withdrawn relative to said reference surface.

4. An exposure installation for exposing a double-sided printed circuit panel to a source of radiation, the installation being **characterised in that** it comprises:
- a top assembly (12) for emitting said radiation;
- a bottom assembly (10) for emitting said radiation and offset in a horizontal direction relative to said top assembly; and
- a panel transfer device according to any one of claims 1 to 3 disposed between said top and bottom assemblies,
- said displacement means being controlled to move separately said bottom slab between the transfer station and the top assembly, and said top slab between said transfer station and said bottom assembly.

## Patentansprüche

1. Vorrichtung zum Befördern und Halten einer doppelseitigen Platte (22), insbesondere einer Platte für eine gedruckte Schaltung, **dadurch gekennzeichnet, daß** sie folgendes umfaßt:
- ein unterer Tisch (16), der eine ebene, horizontale, obere Bezugsfläche aufweist, um die Unterseite der Platte aufzunehmen,
- eine oberer Tisch (14), der eine ebene, horizontale, untere Bezugsfläche aufweist, um die Oberseite der Platte aufzunehmen; und
- Mittel zum Verschieben (18, 20), um die Platten getrennt jeweils in zwei horizontalen Ebenen zu verschieben;
wobei jeder der Tische mit steuerbaren, nicht-mechanischen Mitteln (24) versehen ist, um eine Seite der Platte auf der Bezugsfläche des Tisches zu halten, wenn die Mittel zum Halten aktiviert sind;
- wobei die Einrichtung des weiteren steuerbare Mittel zum Anheben (28) der Platte umfaßt, wobei die Mittel zum Anheben nicht von der Bezugsfläche eines Tisches hervorstehen, wenn sie sich in einem nicht aktivierten Zustand befinden, und sie geeignet sind, die Platten an die Bezugsfläche des oberen Tisches anzulegen, wenn sie aktiviert sind.

2. Vorrichtung nach Anspruch 1, **dadurch gekennzeichnet, daß** die Mittel zum Halten Mikro-Saugdüsen sind, die in die Bezugsfläche des Tisches münden und gleichmäßig auf der Fläche verteilt sind.

3. Vorrichtung nach einem der Ansprüche 1 und 2, **dadurch gekennzeichnet, daß** die Mittel zum Anheben Mikro-Hubzylinder sind, die gleichmäßig in der Bezugsfläche des unteren Tisches angeordnet sind, wobei jeder Mikro-Hubzylinder einen in rechtwinkliger Richtung zu der Bezugsfläche beweglichen Schaft umfaßt, wobei die Schäfte in nicht-aktivierter Position in Bezug auf die Bezugsfläche vollständig zurückspringend sind.

4. Vorrichtung zum Aussetzen von doppelseitigen Platten für gedruckte Schaltungen gegenüber einer Strahlungsquelle, **dadurch gekennzeichnet, daß** sie folgendes umfaßt:
- eine obere Einheit (12) zur Emission der Strahlung;
- eine untere Einheit (10) zur Emission der Strahlung, die in Bezug auf die obere Einheit zur Emission in horizontaler Richtung versetzt ist; und
- eine Einrichtung zum Befördern einer Platte, die zwischen der oberen und der unteren Einheit zur Emission nach einem der Ansprüche 1 bis 3 angeordnet ist,
- wobei die Mittel zum Verschieben gesteuert werden, um den unteren Tisch getrennt zwischen der Beförderungsstation und der oberen Einheit zur Emission und den oberen Tisch zwischen der Beförderungsstation und der unteren Einheit zur Emission zu verschieben.
